# EUROPEAN PATENT SPECIFICATION

(11) **EP 0 572 074 B1**
(45) Date of publication and mention of the grant of the patent: **21.10.1998**
(21) Application number: 93201443.4
(22) Date of filing: 19.05.1993
(51) Int. Cl.: G01R 33/56

(54) **Method and apparatus for magnetic resonance imaging**
Verfahren und Gerät zur Bilderzeugung mittels magnetischer Resonanz
Procédé et appareil d'imagerie par résonance magnétique

(30) Priority: 27.05.1992 EP 92201512
(43) Date of publication of application: 01.12.1993
(73) Proprietor: Koninklijke Philips Electronics N.V., 5621 BA Eindhoven (NL)
(72) Inventor: van Yperen, Gerrit Hendrik, NL-5656 AA Eindhoven (NL); van der Meulen, Peter, NL-5656 AA Eindhoven (NL)
(74) Representative: Schouten, Marcus Maria

(56) References cited:
- EP-A- 529 527
- DE-A- 3 941 188
- US-A- 4 831 329
- US-A- 5 068 609
- US-A- 5 099 208
- US-A- 5 113 865

## Description

The invention relates to a method for magnetic resonance imaging of a body placed in a stationary and substantially homogeneous main magnetic field, the method comprising
- the application of an excitation radio-frequency pulse (RF-pulse) for excitation of nuclear dipole moments in at least a portion of the body,
- the application of a plurality of refocusing RF-pulses following said excitation RF-pulse and of gradient magnetic fields for generating position dependent magnetic resonance signals in the excited portion, the gradient magnetic fields and/or refocusing RF-pulses providing phase encoding of nuclear dipole moments with actual phase encoding values having deviations from nominal phase encoding values,
- the measurement of a set of magnetic resonance signals, the set comprising signals which follow at least a number of said refocusing RF-pulses,
- the transformation of said set of measured magnetic resonance signals into an image, the set of signals being altered prior to said transformation for reducing the effect on said image of the deviations between said actual and said nominal phase encoding values.
The invention also relates to an apparatus for magnetic resonance imaging using such a method.

Such a method for imaging is known from US 5,068,609. The known method is used to reduce the presence of ghosts in the reconstructed image. In the known method the alteration of the set of measured magnetic resonance signals comprises a division of the set in two sub-sets. A first subset containing the even-number rows of said set and a second subset containing the odd-number rows of said set, setting the entries in the remaining rows of the subsets to zero. After Fourier transformation two intermediate images are reconstructed which intermediate images are combined to a single resulting image.

It is, *inter alia,* an object of the invention to provide an alternative magnetic resonance method in accordance to the introductory paragraph in which artefacts in the resulting image are significantly suppressed. Thereto the method according to the invention is characterised in that the alteration of the set of measured signals comprises the measurement of equivalent signals for a substantial fraction of the measured signals to provide two measurements for each phase encoding value and the averaging of measurements of the signal and the equivalent signal for each phase encoding value, the difference between the actual phases and the nominal phases for said signals and said equivalent signals being substantial opposite.

The invention is based upon the realisation that artefacts in the image largely result from incorrect phases and angles imposed locally upon the magnetisation vector and the realisation that small phase errors may cause artefact levels comparable to those due to relatively large amplitude modulations. The invention is also based upon the further realisation that the imperfect RF-pulses and gradient field pulses cause not a random phase deviation but a phase modulation that can largely be compensated for by alteration of the total set of measurements input to the image forming transformation. The alteration of the set of measurements includes addition of a further measurements by providing two measurements for each phase encoding value, the two measurements having opposite phase deviations. The effects of the deviation in the phase encoding values is thereby mitigated.

In a first embodiment of the method according to the invention, wherein signals are measured in a plurality of sequences, each sequence comprising an excitation RF-pulse, a plurality of refocusing RF-pulses alternated with measurements of magnetic resonance signals and switched gradient magnetic fields for phase encoding, wherein for a substantial fraction of the sequences an equivalent sequence is executed in which the same gradient magnetic fields are applied to the body in time-reversed order for time-reversed detection of equivalent measured signals, the same phase encoding value occurring in one sequence in an odd rank number and in the equivalent sequence in an even rank number. In this realisation, as an additional advantage, the decrease in signal amplitude due to spin-spin relaxation, the T₂-decay, within a sequence is compensated by providing identical measurements but with different signal amplitudes. The effect of amplitude modulation due to the T₂-decay, leading to blurring and ringing artefacts in the resulting image, is reduced.

In a second embodiment of the method according to the invention, wherein signals are measured in a plurality of sequences, each sequence comprising an excitation RF-pulse, a plurality of refocusing RF-pulses alternated with measurements of magnetic resonance signals and switched gradient magnetic fields for phase encoding, the equivalent measurements are obtained in an equivalent sequence in which the same gradient magnetic fields are applied to the body in pairwise swapped order. Also in this embodiment the even/odd behaviour of phase deviations over NMR-signals is averaged. This embodiment provides good results, in particular, if the phase variation is not a simple phase alternation. In such circumstances averaging is useful only between signals that are near each other and subject to approximately the same phase deviations. If the number of NMR-signals measured in each sequence is odd one signal remains unpaired and unswapped, this has only little effect upon the quality of the resulting image.

In a third embodiment of the method according to the invention, the equivalent measurements are obtained with the same gradient magnetic field and following subsequent refocusing RF-pulses. If a measurement with the same phase encoding value is to be repeated, for example, because of signal to noise considerations, the measurements with identical phase encoding values are made in the same sequence. Again, the disturbances in phase encoding values due to eddy currents and RF-pulse imperfections are averaged because of the even-odd behaviour of the phase deviation. The number of measurements at each phase encoding value is preferably even for optimum cancelation. An additional advantage of this embodiment is that if the variation in the magnitude of the gradient pulses is gradual, the effect upon the phases of the spins due to eddy currents caused by switching the gradient magnetic fields are to a large extend compensated in subsequent spin-echoes.

In the method according to the invention wherein the refocusing RF-pulses have a value deviating from 180°, and have preferably a value of around 150°. By using a flip-angle other than 180° for the refocusing RF-pulses an exchange between phase and amplitude modulation in the NMR-signals is possible. As artefacts due to phase modulation are suppressed in the invented method, a total reduction of the presence of artefacts can be obtained.

The invention also relates to an apparatus for performing such a method. An apparatus according to the invention for magnetic resonance imaging of a body placed in a stationary and substantially homogeneous main magnetic field according to a method as claimed in any of the method claims, the apparatus comprising means for establishing the main magnetic field, means for generating gradient magnetic fields superimposed upon the main magnetic field, means for radiating RF-pulses towards a body placed in the main magnetic field, control means for steering the generation of the gradient magnetic fields and the RF-pulses, and means for receiving and sampling magnetic resonance signals generated by sequences of RF-pulses and switched gradient magnetic fields, said control means being arranged for
- applying an excitation radio-frequency pulse for excitation of nuclear dipole moments in at least a portion of the body,
- applying a plurality of refocusing RF-pulses following said excitation RF-pulse and gradient magnetic fields for generating position dependent magnetic resonance signals in the excited portion,
- measurement of a set of magnetic resonance signals, the set comprising signals which follow at least a number of said refocusing RF-pulses,
- the apparatus further comprising means for transforming the set of measured magnetic resonance signals into an image, and means altering the set of signals prior to said transformation for reducing the effect on the image of deviations between actual and nominal phase encoding values, deviations which are due to the refocusing RF-pulses and/or switched gradient magnetic fields characterised in that the means altering the set of measured signals being further arranged for the measuring of equivalent signals for a substantial fraction of the measured signals to provide two measurement for each phase encoding value and the averaging of the measurements of the signals and the equivalent signals for each phase encoding value, the difference between the actual phases and the nominal phases for said signals and said equivalent signals being substantial opposite. The alteration of the set of measurements for reduction of artefacts has as an advantage that it is not necessary to modify the construction of the MRI apparatus. In particular, shielding of the coils for generating the gradient magnetic fields in order to reduce the effects of eddy currents can be reduced or done away with completely.

These, and other more detailed aspects of the invention will now be elucidated by way of example with reference to the accompanying drawings.

The drawings show in
Figure 1 diagrammatically a magnetic resonance imaging apparatus, suitable for the method according to the invention;
Figure 2 a sequence of an excitation RF-pulse, a plurality of refocusing RF-pulses, gradient magnetic fields and the occurrence of NMR-signals as a function of time;
Figures 3a and 3b two sequences of RF-pulses and gradient magnetic fields according to a first embodiment of the invention;
Figures 4a and 4b the relative T₂-decay of a single sequence and of two combined sequences according to the first embodiment;
Figures 5a and 5b the central part of the modulus of the point spread function for a single sequence and for two combined sequences according to the first embodiment;
Figures 6a and 6b sequences of RF-pulses and gradient magnetic fields according to another embodiment of the invention;
Figure 7 a sequence of RF-pulses and gradient magnetic fields according to a further embodiment of the invention; and in
Figures 8a and 8b an illustration of phase variations between different NMR-signals.

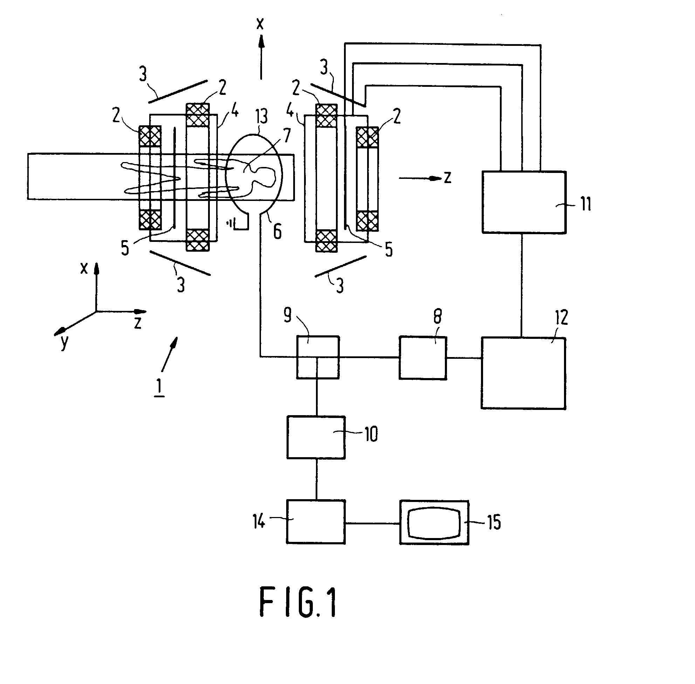

In figure 1 is a magnetic resonance apparatus 1 diagrammatically shown. The apparatus comprises a set of main magnetic coils 2 for generating a stationary homogeneous main magnetic field and several sets of gradient coils 3, 4 and 5 for superimposing additional magnetic fields with controllable strength and having a gradient in a selected direction. Conventionally, the direction of the main magnetic field is labelled the *z* direction, the two directions perpendicular thereto the *x* and *y* directions. The gradient coils are energised *via* a power supply 11. The apparatus further comprises emitting means 6 for emitting radio-frequency pulses (RF-pulses) to an object or body 7, the radiation means being coupled to modulating means 8 for generating and modulating of the RF-pulses. Also provided are means for receiving the NMR-signals, these means can be identical to the emitting means 6 or be separate. If the emitting and receiving means are identical, as shown in the figure, a send-receive switch 9 is arranged to separate the received signals from the pulses to be emitted. The received NMR-signals are input to receiving and demodulating means 10. The emitting means 6 and 8 and the power supply 11 for the gradient coils 3, 4 and 5 are steered by a control system 12 to generate a predetermined sequence of RF-pulses and gradient field pulses. The demodulation means is coupled to a data processing unit 14, for example a computer, for transformation of the received signals into an image that can be made visible, for example on a visual display unit 15.

If the magnetic resonance apparatus 1 is put into operation with an object or body 7 placed in the magnetic field, a small excess of nuclear dipole moments (nuclear spins) in the body will be aligned in the direction of the magnetic field. In equilibrium, this causes a net magnetisation **M**_{**0**} in the material of the body 7, directed in parallel with the magnetic field. In the apparatus 1 the macroscopic magnetisation **M**_{**0**} is manipulated by radiating to the body RF-pulses having a frequency equal to the Larmor frequency of the nuclei, thereby bringing the nuclear dipole moments in an exited state and re-orienting the magnetisation **M**_{**0**}. By applying the proper RF-pulses, a rotation of the macroscopic magnetisation is obtained, the angle of rotation is called the flip-angle. The introduction of variations in the magnetic field by applying gradient magnetic fields influences the behaviour of the magnetisation locally. After the application of RF-pulses, the changed magnetisation will strive to return to a state of thermal equilibrium in the magnetic field, emitting radiation in the process. A well chosen sequence of RF-pulses and gradient field pulses causes this radiation to be emitted as NMR-signals which provide information about the density of a certain type of nuclei, for example hydrogen nuclei, and the substance in which they occur. By analysis of the emitted signals and presentation of it in the form of images, information about the internal structure of the object or body 7 is accessible. For a more detailed descriptions of magnetic resonance imaging (MRI) and MRI-devices reference is made to the extensive literature on this subject, for example to the book "Practical NMR Imaging", edited by M.A. Foster and J.M.S. Hutchinson, 1987, IRL Press.

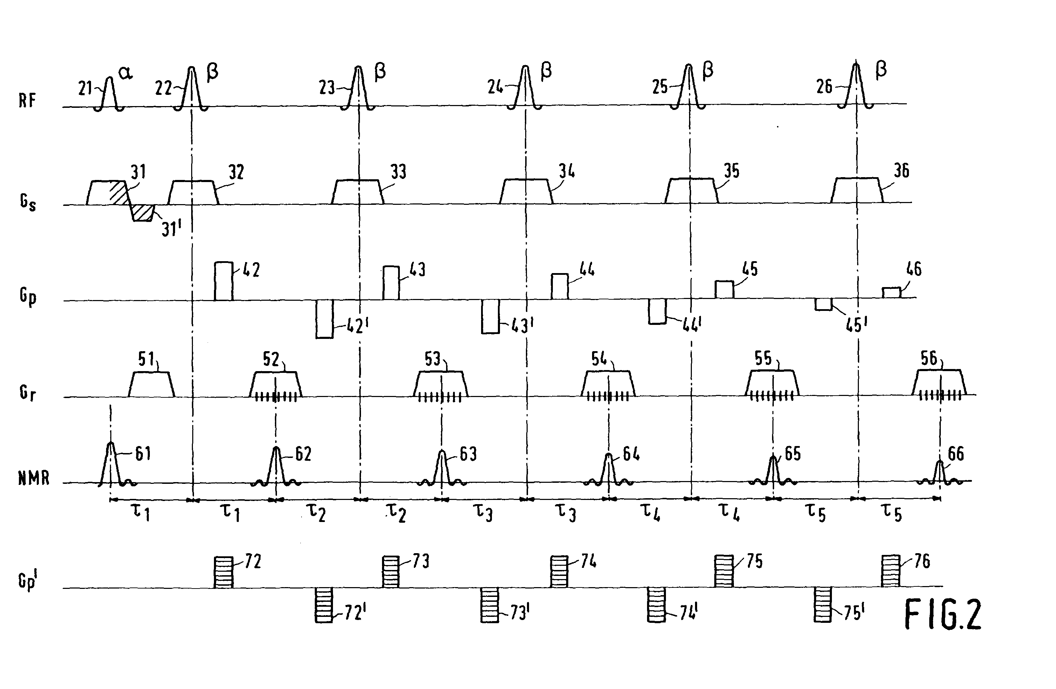

Figure 2 shows a known sequence of RF-pulses and magnetic field gradients for obtaining multiple spin-echo NMR-signals following a single excitation pulse. In the upper line RF the start of the sequence is indicated with an excitation RF-pulse RF-pulse 21 having a flip-angle α, followed after an interval τ₁ by a first refocusing 22 having a flip-angle β. Normally, the values of a and β are 90° and 180°, respectively. Following the excitation RF-pulse 21, a free induction decay (FID) nuclear magnetic resonance signal 61, indicated on the lower line NMR, is generated which dies out rapidly when the individual precessing nuclear magnetic dipole moments lose phase coherence due to local variations in the magnetic field. The refocusing RF-pulse 22 reverses the direction of these individual magnetic dipole moments without affecting the local magnetic field. Consequently, the dephasing is reversed into a rephasing resulting after an equal interval τ₁ in the occurrence of a NMR spin-echo signal 62. After the spin-echo signal 62 the dipole moments dephase again. Repetition of refocusing RF-pulses 23, 24, 25 and 26 cause subsequent reversals of the dephasing and the repeated occurrence of NMR spin-echo signals 63, 64, 65 and 66. Due to non-compensated effects, mainly spin-spin relaxation with a time constant T₂, the magnitude of subsequent echoes decreases in time. The interval lengths τ₂, τ₃, τ₄ and τ₅ between an NMR-signal and the next refocusing RF-pulse are normally chosen to be equal in length.

The effect of the RF-pulses is made selective to a portion of the body 7 by applying, simultaneously with the RF-pulses a slice selection gradient, which is indicated on the second line Gₛ in the figure. As indicated by 31 the slice selection gradient is first applied during the excitation RF-pulse 21. The dephasing caused by this first gradient 31 is compensated by an opposite gradient 31'. Also during the application of the refocusing RF-pulses 22-26 slice selection gradients 32-36 are switched on. For position determination within the selected slice, phase encoding gradient pulses 42, 43, 44, 45 and 46 with the gradient direction within the selected slice, indicated on the third line Gₚ, are applied in the interval between the RF-pulse and the NMR spin-echo signals 62, 63, 64, 65 and 66. In addition, frequency encoding or read gradients 52, 53, 54, 55 and 56, indicated on the fourth line Gᵣ, having a gradient direction also within the selected slice but perpendicular to the gradient direction of the phase encoding field, are switched on during the occurrence of the spin-echo signals. The dephasing effects of the phase encoding gradients is removed after the occurrence of the spin-echo signals by applying further gradient field pulses 42', 43', 44', 45' with the same time-integrated size but with the gradient direction opposite compared to the preceding gradient pulses 42, 43, 44, 45, respectively. The dephasing effect of the read gradients 52, 53, 54, 55 and 56 is compensated for by the refocusing RF-pulses. An initial dephasing gradient 51 preceding the first refocusing RF-pulse 22 is then necessary, this initial dephasing gradient 51 has half the time-integrated size of the read gradients 52, 53, 54, 55 and 56.

Alternatively, not a slice but a volume portion of the body can be selected. In that case the slice selection gradient Gₛ may be absent or adopted for selection of a thick section of the body. In addition to the mentioned gradient fields, a second phase encoding gradient magnetic field Gₚ, is applied having a gradient direction perpendicular to the gradient directions of the first phase encoding field Gₚ and the read gradient field Gᵣ. Like the first phase encoding field Gₚ, this second gradient encoding field is applied as a series of gradient pulses 72, 73, 74, 75, 76, following the RF-pulses and compensating gradient pulses 72', 73', 74', 75', following the NMR-signals. As indicated by horizontal lines in gradient pulses 72-76 and 72'-76', the size of the second phase encoding gradient pulses are kept constant when the first phase encoding gradient pulses are varied. Alternatively, the first phase encoding gradient pulses 42-46 and 42'-45' may be kept constant and the second phase encoding gradient pulses be varied within a sequence. Hereinafter, the embodiments of the invention are described in the two-dimensional slice selection mode. However, extension to three-dimensional volume imaging by the application of a second phase encoding field is straightforward.

After acquisition of the NMR-signals, for example 256 spin-echo signals each with a different phase encoding value and each sampled 256 times, the total set of measurements is converted into an image by means of a Fourier transform (FT). As a consequence of the above described procedure two kinds of image errors may appear in the resulting image. The first is that the signal size of subsequent NMR-signals in a sequence reduces due to spin-spin relaxation, the T₂-decay, this causes blurring in the resulting image. A second, and as it appears, more important source of image errors is that imperfections in the switched gradient magnetic field pulses and the refocusing RF-pulses cause residual phase effects in the spins. These residual phase effects provide a false position information and show as artefacts and ghosts in the image after Fourier transformation.

The residual phase effects caused by the refocusing RF-pulses is due to the presence of the slice selection gradient, that prohibits a uniform flip-angle β to occur across the full thickness of the selected slice. The imperfections in the gradient magnetic field pulses are due to timing errors and eddy currents in the gradient coils for generating the gradient fields. These timing errors and eddy currents influence the time-integrated size of the gradient pulses. Consequently, some residual gradient field is left after each measurement cycle, the residual gradient field causing an additional and undesired phase encoding effect.

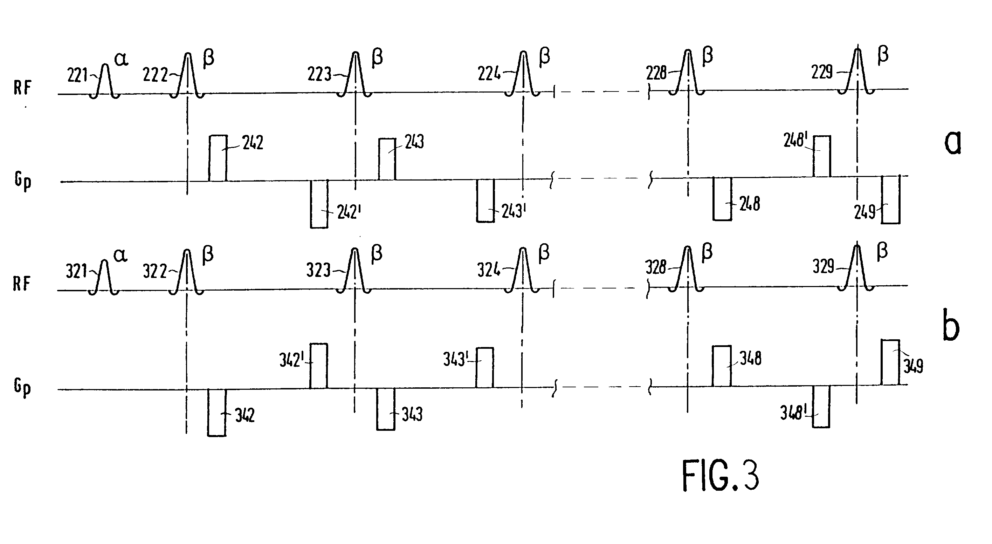

In figures 3a and 3b, two sequences of RF-pulses and gradient magnetic field pulses for obtaining NMR-signals according to a first embodiment of the invention are shown. As the sequences are identical with the sequence shown in figure 2, the phase encoding gradient G_{P} excepted, only the G_{P} gradients and the RF-pulses are shown. The first and last few RF-pulses and accompanying gradient pulses are indicated only. The sequence of phase encoding gradient pulses 242, 243, **...,** 248 and 249, shown in figure 3a is linearly decreasing. The sequence of figure 3b has linearly increasing phase encoding gradient pulses 342, 343, ..., 348 and 349, the phase encoding in the two chains being time reversed copies of each other. After executing both sequences there are two measurements for each phase encoding value. If the sequences have an even number of refocusing RF-pulses, one of the two measurements follows an RF-pulse with an even and one with an odd rank number. Consequently, the phase error caused by imperfect RF-pulses and switched gradient fields is in first order opposite and the effect of two measurements is that the errors largely cancel. A second effect is that the T₂-decay, occurring in the course of a sequence is compensated for as one measurement is taken in the first half of a sequence and one is taken in the second half.

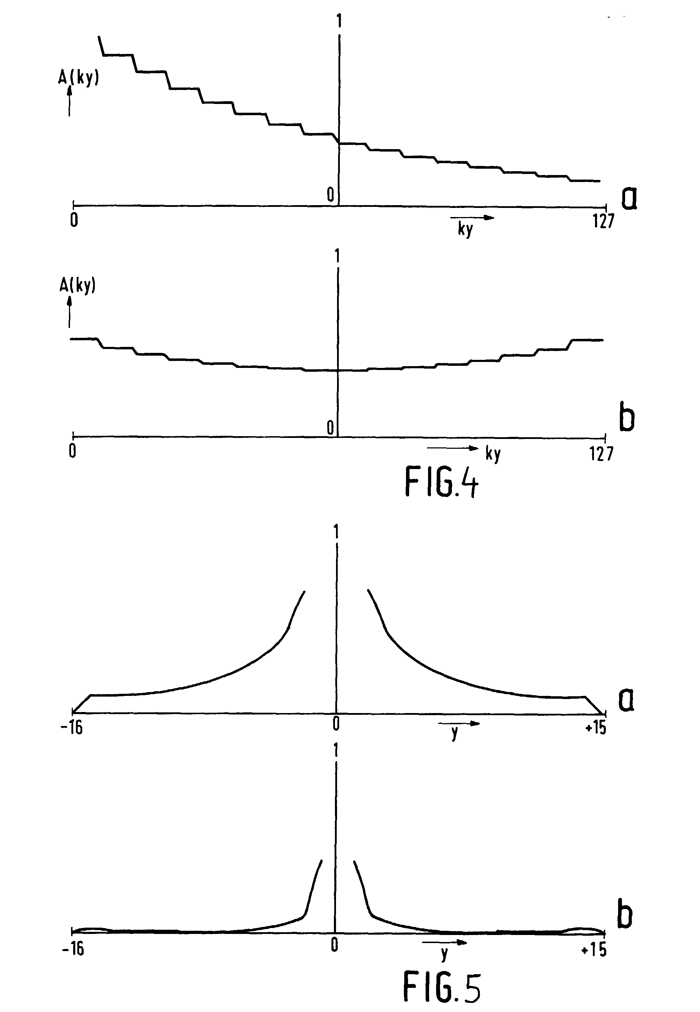

In figures 4a and 4b the relative T₂-decay A(k_{y}) of a single sequence and of two combined time-reversed sequences is shown as a function of the phase encoding value k_{y}, for 128 different phase encoding values determined in a series of interleaved sequences. As expected, the combined time reversed sequence shows much less amplitude variation. In figures 5a and 5b the central part of the modulus of the point spread function is shown for both situations. As can be seen, the combination of two time-reversed sequences leads to a considerable narrower PSF(y). This indicates that artefacts and blurring due to the phase deviations and T₂-decay are largely removed in the resulting image. Investigation of the real and imaginary parts of PSF(y) shows that the imaginary part is strongly reduced.

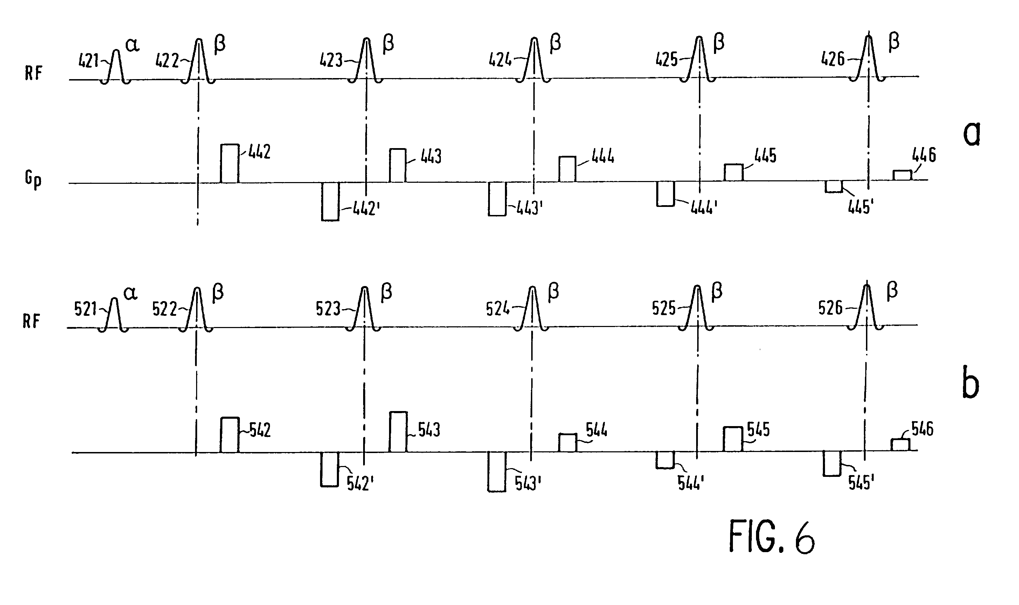

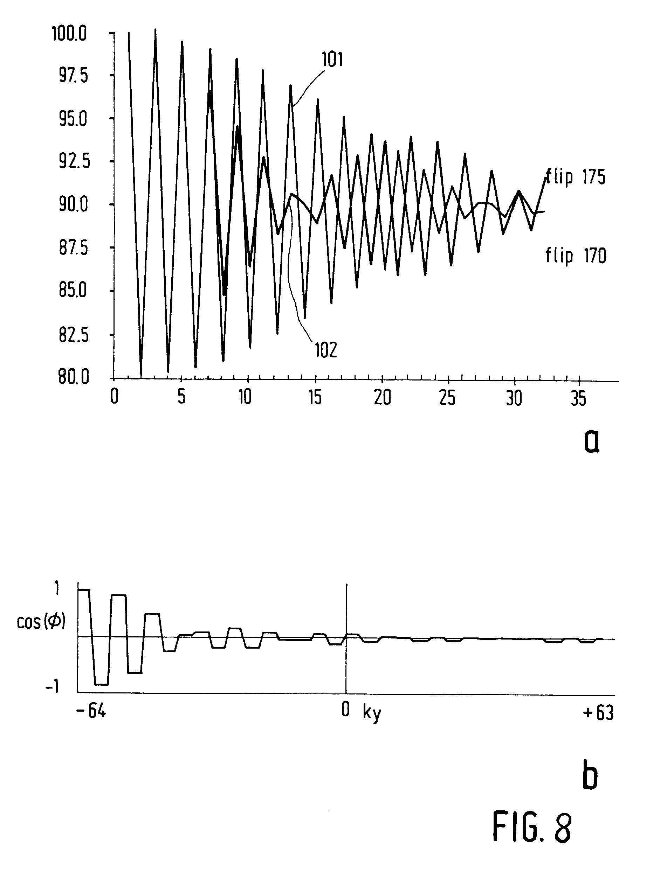

Figures 6a and 6b show two sequences of RF-pulses and gradient magnetic field pulses for obtaining NMR-signals according to another embodiment of the invention are shown. Like in figures 3a and 3b, only the Gₚ gradients and the RF-pulses are shown, the other gradient magnetic fields being identical to the ones shown in figure 2. Only the first few RF-pulses and accompanying gradient field pulses are indicated only. The sequence of phase encoding gradient pulses 442, 443, 444, ..., shown in figure 6a is identical to the sequence shown in figure 2. In the sequence of figure 6b the phase encoding gradient pulses 542, 543, 544, ..., are pairwise swapped compared to the earlier sequence. The first (second) phase encoding gradient pulse 542 (543) in the second sequence being equal to the second (first) phase encoding gradient pulse 443 (442) in the first sequence, the third (fourth) phase encoding gradient pulse 544 (545) in the second sequence being equal to the fourth (third) phase encoding gradient pulse 445 (444) in the first sequence, etc. After executing both sequences there are two measurements for each phase encoding value, one following an RF-pulse with an even and one with an odd rank number. If the number of measurements is odd, this method can still be applied by leaving the last measurement unswapped. As in the sequences shown in figures 3a and 3b, the phase errors caused by imperfect RF-pulses and switched gradient fields largely cancel. Despite the fact that the measured NMR-signals have a larger amplitude variation due to the T₂-decay, this embodiment gives better results in case the phase variation is more complicated than a simple alternation, for example, due to beat causing a phase change effect over a longer portion of a sequence. Examples of such behaviour are shown in figures 8a and 8b, where curve 104 shows a beat pattern with nodes near echo numbers 13 and 26.

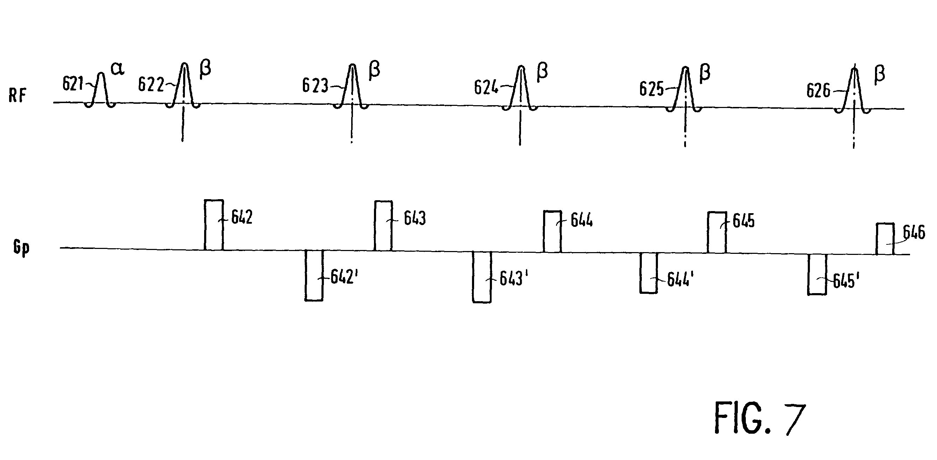

In figure 7 a further embodiment is shown. As hereinbefore, only the first few RF-pulses and phase encoding gradient pulses are indicated. In this embodiment a, preferably even, number of measurements with identical phase encoding gradients is performed consecutively. In figure 7 the number is two. The first two phase encoding gradient pulses 642 and 643 have identical values, as well as the second two 644 and 645, *etc.* As the size of the gradient pulses changes only gradually, the effect of eddy currents upon the phase of the nuclear spins is largely compensated due to the refocusing effect of the refocusing RF-pulses.

Figures 8a and 8b illustrate phase variations that may occur in a sequence of measuring NMR-signals. A data acquisition sequence, for example, a conventional sequence such as shown in figure 2 or a modified sequence as describe hereinbefore, comprises phase shifts at the level of the nuclear dipole moments, which phase shifts are caused by system imperfections, such as phase errors in the RF-pulses or eddy currents. As the flip angle of the refocussing RF-pulses is not a perfect 180°, the imperfections give rise to oscillations in the NMR-signal phase. The oscillations reduce with increasing rank number of the measured NMR-signal. The same kind of oscillations occur when the flip-angle of the refocusing RF-pulses differ from 180°. In figure 8a curve 101 connects the phases of NMR spin-echo signals occurring in a sequence in which there is a 10° phase deviation between the excitation RF-pulse and the refocusing RF-pulses, and in which the refocusing RF-pulses have a flip-angle of 175°. The curve 102 shows the phase behaviour for measurements with a 170° flip-angle of the refocusing RF-pulse and also a 10° phase deviation between excitation and refocusing RF-pulses. As the flip-angle of the refocusing pulses is not well determined but a distribution of a continuous range of flip-angles, the total contribution vanishes rapidly. This is illustrated in figure 8b, showing the cosine of the total phase contribution cos(φ) for a number of different flip angles as a function of the phase encoding value k_{y}. As the k_{y} values are chosen to be interleaved and increasing with the echoes, the k_{y} value is closely related to the echo number.

## Claims

1. Method for magnetic resonance imaging of a body placed in a stationary and substantially homogeneous main magnetic field, the method comprising
- the application of an excitation radio-frequency pulse (RF-pulse) for excitation of nuclear dipole moments in at least a portion of the body,
- the application of a plurality of refocusing RF-pulses following said excitation RF-pulse and of gradient magnetic fields for generating position dependent magnetic resonance signals in the excited portion, the gradient magnetic fields and/or refocusing RF-pulses providing phase encoding of nuclear dipole moments with actual phase encoding values having deviations from nominal phase encoding values,
- the measurement of a set of magnetic resonance signals, the set comprising signals which follow at least a number of said refocusing RF-pulses,
- the transformation of said set of measured magnetic resonance signals into an image, the set of signals being altered prior to said transformation for reducing the effect on said image of the deviations between said actual and said nominal phase encoding values, characterised in that the alteration of the set of measured signals comprises the measurement of equivalent signals for a substantial fraction of the measured signals to provide two measurements for each phase encoding value and the averaging of measurements of the signal and the equivalent signal for each phase encoding value, the difference between the actual phases and the nominal phases for said signals and said equivalent signals being substantial opposite.

2. Method according to claim 1, wherein signals are measured in a plurality of sequences, each sequence comprising an excitation RF-pulse, a plurality of refocusing RF-pulses alternated with measurements of magnetic resonance signals and switched gradient magnetic fields for phase encoding, wherein for a substantial fraction of the sequences an equivalent sequence is executed in which the same gradient magnetic fields are applied to the body in time-reversed order for time-reversed detection of equivalent measured signals, the same phase encoding value occurring in one sequence in an odd rank number and in the equivalent sequence in an even rank number.

3. Method according to claim 1, wherein signals are measured in a plurality of sequences, each sequence comprising an excitation RF-pulse, a plurality of refocusing RF-pulses alternated with measurements of magnetic resonance signals and switched gradient magnetic fields for phase encoding, the equivalent measurements are obtained in an equivalent sequence in which the same gradient magnetic fields are applied to the body in pairwise swapped order.

4. Method according to claim 1, wherein the equivalent measurements are obtained with the same gradient magnetic field and following subsequent refocusing RF-pulses.

5. Method according to any one of the preceding claims, wherein the refocusing RF-pulses have a value deviating from 180°, and have preferably a value of around 150°.

6. Apparatus for magnetic resonance imaging of a body (7) placed in a stationary and substantially homogeneous main magnetic field according to a method as claimed in any of the preceding claims, the apparatus comprising means for establishing the main magnetic field (2), means for generating gradient magnetic fields (3,4,5) superimposed upon the main magnetic field, means (6,8) for radiating RF-pulses towards a body (7) placed in the main magnetic field, control means (12) for steering the generation of the gradient magnetic fields and the RF-pulses, and means for receiving (6,10) and sampling magnetic resonance signals generated by sequences of RF-pulses and switched gradient magnetic fields, said control means (12) being arranged for
- applying an excitation radio-frequency pulse (RF-pulse) for excitation of nuclear dipole moments in at least a portion of the body,
- applying a plurality of refocusing RF-pulses following said excitation RF-pulse and gradient magnetic fields for generating position dependent magnetic resonance signals in the excited portion,
- measurement of a set of magnetic resonance signals, the set comprising signals which follow at least a number of said refocusing RF-pulses,
- the apparatus further comprising means for transforming the set of measured magnetic resonance signals into an image, and means altering the set of signals prior to said transformation for reducing the effect on the image of deviations between actual and nominal phase encoding values, deviations which are due to the refocusing RF-pulses and/or switched gradient magnetic fields characterised in that the means altering the set of measured signals being further arranged for the measuring of equivalent signals for a substantial fraction of the measured signals to provide two measurement for each phase encoding value and the averaging of the measurements of the signals and the equivalent signals for each phase encoding value, the difference between the actual phases and the nominal phases for said signals and said equivalent signals being substantial opposite.

## Patentansprüche

1. Verfahren zur Kernresonanzabbildung eines in ein stationäres und nahezu homogenes Hauptmagnetfeld eingebrachten Körpers, wobei das Verfahren umfaßt
- das Anlegen eines Anregungshochfrequenzimpulses (HF-Impuls), zur Anregung von Kerndipolmomenten in zumindest einem Teil des Körpers,
- das Anlegen einer Vielzahl von refokussierenden HF-Impulsen, die dem genannten Anregungs-HF-Impuls folgen, und von Gradientenmagetfeldern zum Generieren von positionsabhängigen Kernresonanzsignalen in dem angeregten Teil, wobei die Gradientenmagnetfelder und/oder refokussierenden HF-Impulse Phasencodierung von Kerndipolmomenten mit Phasencodierungsistwerten verschaffen, die Abweichungen von Phasencodierungsnennwerten haben,
- die Messung einer Menge von Kernresonanzsignalen, wobei die Menge Signale umfaßt, die zumindest einer Anzahl der genannten refokussierenden HF-Impulse folgen,
- die Transformation der genannten Menge von gemessenen Kernresonanzsignale in ein Bild, wobei die Menge von Signalen vor der genannten Transformation geändert wird, um die Auswirkung der Abweichungen zwischen den genannten Istwerten und Nennwerten der Phasencodierung auf das genannte Bild zu verringern, dadurch gekennzeichnet daß die Änderung der Menge von gemessenen Signalen das Messen von äquivalenten Signalen für einen wesentlichen Anteil der gemessenen Signale umfaßt, um zwei Messungen für jeden Phasencodierungswert und die Mittelung der Messungen des Signals und des äquivalenten Signals für jeden Phasencodierungswert zu verschaffen, wobei die Differenz zwischen den Istphasen und den Nennphasen für die genannten Signale und die genannten äquivalenten Signale im wesentlichen entgegengesetzt ist.

2. Verfahren nach Anspruch 1, bei dem Signale in einer Vielzahl von Sequenzen gemessen werden, wobei jede Sequenz einen Anregungs-HF-Impuls, eine Viel; zahl von refokussierenden HF-Impulsen abgewechselt mit Messungen von Kernresonanzsignalen und geschaltete Gradientenmagnetfelder zur Phasencodierung umfaßt, bei dem für einen wesentlichen Anteil der Sequenzen eine äquivalente Sequenz ausgeführt wird, in der die gleichen Gradientenmagnetfelder in zeitlich umgekehrter Reihenfolge zur zeitlich umgekehrten Detektion äquivalenter gemessener Signale an den Körper angelegt werden, wobei der gleiche Phasencodierungswert in einer Sequenz in einer ungeraden Rangnummer und in der äquivalenten Sequenz in einer geraden Rangnummer auftritt.

3. Verfahren nach Anspruch 1, bei dem Signale in einer Vielzahl von Sequenzen gemessen werden, wobei jede Sequenz einen Anregungs-HF-Impuls, eine Vielzahl von refokussierenden HF-Impulsen abgewechselt mit Messungen von Kernresonanzsignalen und geschaltete Gradientenmagnetfelder zur Phasencodierung umfaßt, wobei die äquivalenten Messungen in einer äquivalenten Sequenz erhalten werden, in der die gleichen Gradientenmagnetfelder in paarweise vertauschter Reihenfolge an den Körper gelegt werden.

4. Verfahren nach Anspruch 1, bei dem die äquivalenten Messungen mit dem gleichen Gradientenmagnetfeld und auf nachfolgende refokussierende HF-Impulse folgend erhalten werden.

5. Verfahren nach einem der vorhergehenden Ansprüche, bei dem die refokussierenden HF-Impulse einen von 180° abweichenden Wert haben, und vorzugsweise einen Wert um 150°.

6. Gerät zur Kernresonanzabbildung eines in ein stationäres und nahezu homogenes Hauptmagnetfeld eingebrachten Körpers (7) gemäß einem Verfahren nach einem der vorhergehenden Ansprüche, wobei das Gerät Mittel zum Aufbauen des Hauptmagnetfeldes (2), Mittel zum Erzeugen von dem Hauptmagnetfeld überlagerten Gradientenmagnetfeldern (3,4,5), Mittel (6,8) zum Abstrahlen von HF-Impulsen hin zu einem in das Hauptmagnetfeld eingebrachten Körper (7), Steuerungsmittel (12) zum Ansteuern der Erzeugung der Gradientenmagnetfelder und der HF-Impulse, und Mittel zum Empfangen (6,10) und Abtasten von Kernresonanzsignalen, die von Sequenzen von HF-Impulsen und geschalteten Gradientenmagnetfeldern generiert worden sind, wobei die genannten Steuerungsmittel (12) ausgebildet sind,
- um einen Anregungshochfrequenzimpuls (HF-Impuls) zur Anregung von Kerndipolmomenten in zumindest einem Teil des Körpers anzulegen,
- um eine Vielzahl von refokussierenden HF-Impulsen, die dem genannten Anregungs-HF-Impuls folgen, sowie Gradientenmagnetfelder zum Generieren positionsabhängiger Kernresonanzsignale in dem angeregten Teil anzulegen,
- zum Messen einer Menge von Kernresonanzsignalen, wobei die Menge Signale umfaßt, die zumindest einer Anzahl der genannten refokussierenden HF-Impulse folgen,
- wobei das Gerät weiterhin Mittel umfaßt zur Transformation der Menge von gemessenen Kernresonanzsignale in ein Bild und Mittel, die die Menge von Signalen vor der genannten Transformation ändern, um die Auswirkung von Abweichungen zwischen Istwerten und Nennwerten der Phasencodierung auf das genannte Bild zu verringern, wobei die Abweichungen auf refokussierenden HF-Impulsen und/oder geschalteten Gradientenmagnetfeldern beruhen, dadurch gekennzeichnet, daß die Mittel, die die Menge von gemessenen Signalen ändern, weiterhin ausgebildet sind zum Messen von äquivalenten Signalen für einen wesentlichen Anteil der gemessenen Signale, um zwei Messungen für jeden Phasencodierungswert und die Mittelung der Messungen der Signale und der äquivalenten Signale für jeden Phasencodierungswert zu verschaffen, wobei die Differenz zwischen den Istphasen und den Nennphasen für die genannten Signale und die genannten äquivalenten Signale im wesentlichen entgegengesetzt ist.

## Revendications

1. Procédé d'imagerie par résonance magnétique d'un corps placé dans un champ magnétique principal statique et sensiblement homogène, le procédé comprenant :
- l'application d'une impulsion de radiofréquence (impulsion RF) d'excitation pour l'excitation de moments dipolaires nucléaires dans au moins une partie du corps;
- l'application d'une pluralité d'impulsions RF de refocalisation succédant à cette impulsion RF d'excitation et de champs magnétiques de gradient pour engendrer des signaux de résonance magnétique dépendant de la position dans la partie excitée, les champs magnétiques de gradient et/ou les impulsions RF de refocalisation assurant le codage de phase des moments dipolaires nucléaires à l'aide de valeurs de codage de phase réelles présentant des déviations par rapport aux valeurs de codage de phase nominales;
- la mesure d'un jeu de signaux de résonance magnétique, le jeu comprenant des signaux qui succèdent à au moins un certain nombre desdites impulsions RF de refocalisation, et
- la transformation de ce jeu de signaux de résonance magnétique mesurés en une image, le jeu de signaux étant modifié avant ladite transformation pour atténuer l'effet exercé sur l'image par les déviations entre les valeurs de codage de phase réelles et nominales,
caractérisé en ce que la modification du jeu de signaux mesurés comprend la mesure de signaux équivalents pour une fraction appréciable des signaux mesurés afin de fournir deux mesures pour chaque valeur de codage de phase et le moyennage des mesures du signal et du signal équivalent pour chaque valeur de codage de phase, les différences entre les phases réelles et les phases nominales pour lesdits signaux et lesdits signaux équivalents étant en substance opposées.

2. Procédé suivant la revendication 1, dans lequel les signaux sont mesurés dans une pluralité de séquences, chaque séquence comprenant une impulsion RF d'excitation, une pluralité d'impulsions RF de refocalisation alternant avec des mesures de signaux de résonance magnétique et des champs magnétiques de gradient commutés pour le codage de phase, dans lequel pour une fraction notable des séquences, une séquence équivalente est exécutée dans laquelle les mêmes champs magnétiques de gradient sont appliqués au corps dans un ordre inversé dans le temps pour la détection inversée dans le temps de signaux mesurés équivalents, la même valeur de codage de phase apparaissant dans une séquence dans un numéro de rang impair et dans la séquence équivalente dans un numéro de rang pair

3. Procédé suivant la revendication 1, dans lequel les signaux sont mesurés dans une pluralité de séquences, chaque séquence comprenant une impulsion RF d'excitation, une pluralité d'impulsions RF de refocalisation alternant avec des mesures de signaux de résonance magnétique et des champs magnétiques de gradient commutés pour le codage de phase, les mesures équivalentes sont obtenues dans une séquence équivalente dans laquelle les mêmes champs magnétiques de gradient sont appliqués au corps dans un ordre de transfert alterné par paire.

4. Procédé suivant la revendication 1, dans lequel les mesures équivalentes sont obtenues avec le même champ magnétique de gradient et après les impulsions RF de refocalisation ultérieures.

5. Procédé suivant l'une quelconque des revendications précédentes, dans lequel des impulsions RF de refocalisation ont une valeur déviant de 180° et, de préférence, une valeur voisine de 150°.

6. Appareil pour l'imagerie par résonance magnétique d'un corps (7) placé dans un champ magnétique principal statique et sensiblement homogène selon un procédé suivant l'une quelconque des revendications précédentes, l'appareil comprenant des moyens pour établir le champ magnétique principal (2), des moyens pour engendrer des champs magnétiques de gradient (3, 4, 5) superposés au champ magnétique principal, des moyens (6, 8) pour émettre des impulsions RF vers un corps (7) placé dans le champ magnétique principal, des moyens de commande (12) pour piloter la génération des champs magnétiques de gradient et des impulsions RF, et des moyens pour recevoir (6, 10) et échantillonner les signaux de résonance magnétique engendrés par des séquences d'impulsions RF et de champs magnétiques de gradient mis en action, ces moyens de commande (12) étant agencés pour :
- appliquer une impulsion de radiofréquence (impulsion RF) d'excitation pour l'excitation des moments dipolaires nucléaires dans au moins une partie du corps;
- appliquer une pluralité d'impulsions RF de refocalisation succédant à ladite impulsion RF d'excitation et aux champs magnétiques de gradient pour engendrer des signaux de résonance magnétique dépendant de la position dans la partie excitée;
- mesurer un jeu de signaux de résonance magnétique, le jeu comprenant des signaux qui succèdent à au moins un certain nombre des impulsions RF de refocalisation, et
- l'appareil comprenant, de surcroît, des moyens pour transformer le jeu de signaux de résonance magnétique mesurés en une image et des moyens modifiant le jeu de signaux avant cette transformation pour atténuer l'effet exercé sur l'image par les déviations entre les valeurs de codage de phase réelles et nominales, déviations qui sont dues aux impulsions RF de refocalisation et/ou champs magnétiques de gradient mis en action, caractérisé en ce que les moyens modifiant le jeu de signaux mesurés sont, en outre, agencés pour mesurer des signaux équivalents pour une fraction sensible de signaux mesurés afin d'obtenir deux mesures pour chaque valeur de codage de phase et pour acquérir la moyenne des mesures des signaux et les signaux équivalents pour chaque valeur de codage de phase, les différences entre les phases actuelles et les phases nominales pour lesdits signaux et lesdits signaux équivalents étant sensiblement opposées.
